# EUROPEAN PATENT APPLICATION

(11) **EP 2 947 682 A1**
(43) Date of publication of application: **25.11.2015**
(21) Application number: 15163524.0
(22) Date of filing: 14.04.2015
(51) Int. Cl.: H01L 21/36, H01L 31/18

(54) **METHOD FOR FORMING CHALCOGENIDE LAYERS**

(30) Priority: 20.05.2014 EP 14168924
(71) Applicant: IMEC VZW, 3001 Leuven (BE); King Abdulaziz City for Science and Technology, Riyadh 11442 (SA); Universiteit Hasselt, 3500 Hasselt (BE)
(72) Inventor: Oueslati, Souhaib, 3001 Leuven (BE)
(74) Representative: Clerix, André

(57) **Abstract**

A method is provided for forming on a substrate a chalcogenide layer, the chalcogenide layer containing at least two metallic elements and containing Se. The method comprises depositing on the substrate a metallic layer containing the at least two metallic elements; and annealing the metallic layer in an environment comprising both a S containing vapour such as H₂S vapour and a Se containing vapour such as H₂Se vapour, thereby forming the chalcogenide layer. The annealing may for example be done at a temperature in the range between 450°C and 550°C, resulting in a layer with good morphological quality and large grain size, the layer being free of S. A method of the present disclosure may for example be used for forming an absorber layer of a photovoltaic cell.

## Description

### Field

The present disclosure is related to methods for forming chalcogenide layers having a well-controlled composition. Such chalcogenide layers may for example be used as an absorber layer in chalcogenide based photovoltaic cells.

### State of the art

Chalcopyrite ternary thin layers, such as copper-indium-gallium-sulfoselenide (CuIn_{1-X}Ga_{X}(S,Se)₂) layers, and kesterite quaternary thin layers, such as copper-zinc-tin-sulfoselenide (Cu₂ZnSn(S,Se)₄) layers, generically referred to as CIGS layers and CZTS layers respectively, have become the subject of considerable interest and study for their use in semiconductor devices in recent years. These materials are also referred to as I-III-VI₂ and I₂-II-IV-VI₄ materials according to their constituent elemental groups. These materials are of particular interest for use as an absorber layer in photovoltaic devices.

For photovoltaic applications, a p-type CIGS or CZTS layer may be combined with a thin n-type semiconductor layer such as for example a CdS layer to form a p-n heterojunction CdS/CIGS or CdS/CZTS device.

A known method for forming a CIGS or CZTS layer on a substrate is based on the deposition of the metallic precursor metals on the substrate, thereby forming a metallic layer, followed by annealing in a chalcogen containing ambient to form the chalcogenide layer. Deposition of the metallic precursor metals may for example be done by co-evaporation or co-sputtering (or, alternatively, sequential sputtering) of the metallic precursor materials (I-III or I-II-IV elements) on the substrate at ambient temperature. The annealing may for example be done in a selenide vapour ambient. This process is known as a selenization process. During selenization, Se is incorporated into the metallic layer and a Se containing chalcogenide layer is formed. As an alternative, the annealing may be done in a sulfide vapour environment. This process is known as a sulfurization process. During sulfurization, S is incorporated into the metallic layer and a S containing chalcogenide layer is formed.

Because of the variety and complexity of the reactions taking place during the selenization process or during the sulfurization process, the composition and properties of the resulting chalcogenide layers are difficult to control. For example, during the selenization process (or alternatively: sulfurization process), metals may evaporate from the metallic layer, resulting in an uncontrolled composition of the chalcogenide layer. This makes the optimization of the initial metallic layer composition difficult and causes the metal ratio after selenization or sulfurization to be pseudorandom.

When using such a chalcogenide layer with an uncontrolled composition as an absorber layer in a photovoltaic cell, this results in a low or unpredictable photovoltaic cell efficiency, and in some cases it may result in a non-functional photovoltaic cell.

### Summary

The present disclosure aims to provide a method for forming chalcogenide layers wherein the composition can be well controlled. More in particular, the present disclosure aims to provide a method for forming Se containing chalcogenide layers having a well-controlled composition.

The present disclosure aims to provide a method for forming chalcogenide layers with a large average grain size, e.g. an average grain size that is larger than the average grain size of chalcogenide layers formed using known methods. Using a method according to the present disclosure, chalcogenide layers having an average grain size larger than 1 micrometer, for example larger than 3 micrometer, or larger than 5 micrometer may be formed.

The disclosure is related to a method for forming on a substrate a chalcogenide layer, the chalcogenide layer containing at least two different metallic elements and containing Se, wherein the method comprises: depositing on the substrate a metallic layer containing the at least two metallic elements; and annealing the metallic layer in an environment comprising both a S containing vapour and a Se containing vapour, thereby forming the chalcogenide layer.

In embodiments of the present disclosure, the S containing vapour may for example be a H₂S vapour and/or the Se containing vapour may for example be a H₂Se vapour, the present disclosure not being limited thereto.

In embodiments of the present disclosure a vapour pressure of the S containing vapour may be higher than a vapour pressure of the Se containing vapour.

In the context of the present disclosure, a metallic layer is a layer containing only metallic elements. In the context of the present disclosure, a metallic layer does not contain elements other than metallic elements, e.g. it does not contain a chalcogen element.

It was surprisingly found that a chalcogenide layer formed according to a method of the present disclosure has a well-controlled composition. It was surprisingly found that the amount of metallic elements lost (e.g. by evaporation) during the annealing or selenization process is lower as compared to a method wherein the annealing or selenization is done in the absence of a S containing vapour, e.g. in the absence of H₂S.

It was surprisingly found that a chalcogenide layer formed according to a method of the present disclosure is free of Sulphur, i.e. the chalcogenide layer does not contain any Sulphur.

In a method according to the present disclosure, the annealing may be performed at a temperature in the range between 450°C and 550°C. It is an advantage of a method of the present disclosure that the annealing (selenization process) can be done at a temperature that is higher than in prior art selenization processes, without the risk of segregation of chalcogenide grains and without the risk of evaporation of metallic elements from the metallic layer.

It is an advantage of using a higher annealing temperature that larger grains may be obtained. When used as an absorber layer in a photovoltaic cell, a chalcogenide layer with larger grain size may result in a larger cell efficiency.

Depositing the metallic layer may comprise sequentially depositing the at least two metallic elements. Alternatively, depositing the metallic layer may comprise simultaneously depositing (co-depositing) the at least two metallic elements.

In embodiments of the present invention the metallic layer may for example contain three different metallic elements. For example, when using a method of the present disclosure for forming a CIGSe chalcogenide layer, the metallic layer may contain Cu, In and Ga. For example, when using a method of the present disclosure for forming a CZTSe chalcogenide layer, the metallic layer may contain Cu, Zn and Sn.

A method according to the present disclosure may advantageously be used for forming a chalcogenide semiconductor layer, such as for example an absorber layer of a photovoltaic cell.

It is an advantage of a method according to the present disclosure that it allows forming Se containing chalcogenide layers with a well-controlled composition in a reproducible way.

It is an advantage of a method according to the present disclosure that it results in chalcogenide layers of good morphological quality and with a relatively large average grain size. For example, the average grain size may be larger than 3 micrometer, e.g. larger than 5 micrometer.

Certain objects and advantages of various inventive aspects have been described herein above. Of course, it is to be understood that not necessarily all such objects or advantages may be achieved in accordance with any particular embodiment of the disclosure. Thus, for example, those skilled in the art will recognize that the disclosure may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the disclosure. The disclosure, both as to organization and method of operation, together with features and advantages thereof, may best be understood by reference to the following detailed description.

### Brief description of the figures

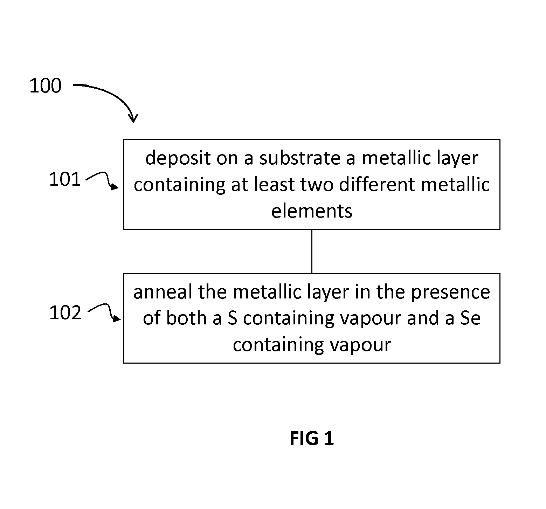

FIG 1 illustrates process steps of a method according to an embodiment of the present disclosure.

Any reference signs in the claims shall not be construed as limiting the scope of the present disclosure.

In the different drawings, the same reference signs refer to the same or analogous elements.

The drawings are only schematic and are non-limiting. In the drawings, the size of some of the elements may be exaggerated and not drawn on scale for illustrative purposes.

### Detailed description

In the following detailed description, numerous specific details are set forth in order to provide a thorough understanding of the disclosure and how it may be practiced in particular embodiments. However, it will be understood that the present disclosure may be practiced without these specific details. In other instances, well-known methods, procedures and techniques have not been described in detail, so as not to obscure the present disclosure.

The present disclosure will be described with respect to particular embodiments but the disclosure is not limited thereto but only by the claims.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the disclosure described herein are capable of operation in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

A method for forming on a substrate a chalcogenide layer with a well-controlled composition is provided, the chalcogenide layer comprising at least two different metallic elements and Se. FIG 1 illustrates process steps of a method 100 according to an embodiment of the present disclosure. The method comprises, at step 101, depositing on the substrate a metallic layer containing the at least two different metallic elements and, at step 102, annealing the metallic layer in an environment comprising both a S containing vapour, such as for example a H₂S vapour, and a Se containing vapour, such as for example a H₂Se vapour, thereby forming the chalcogenide layer. During the annealing step, the vapour pressure of the S containing vapour is preferably higher than the vapour pressure of the Se containing vapour.

In embodiments of the present disclosure the annealing 102 may for example be performed at a temperature in the range between 450°C and 550°C, such as for example in the range between 460°C and 520°C, the present disclosure not being limited thereto. The annealing may for example be performed for 5 minutes to 1 hour, for example 10 minutes to 30 minutes, for example about 15 minutes.

It was surprisingly found that a method of the present disclosure leads to chalcogenide layers with good morphological quality, the chalcogenide layers having a reduced number of voids and a reduced amount of secondary phases as compared to chalcogenide layers formed by known methods. Such chalcogenide layers may advantageously be used as an absorber layer in a photovoltaic cell. As compared to prior art methods, less metal is lost (e.g. by evaporation) from the metallic layer during annealing, even at an annealing temperature higher than 500°C.

In embodiments of the present disclosure, depositing 101 the metallic layer may comprise co-depositing, e.g. co-sputtering, the at least two metallic elements. In embodiments of the present disclosure, depositing 101 the metallic layer may comprise sequentially depositing, e.g. sequentially sputtering, the at least two metallic elements.

In embodiments of the present disclosure, a H₂S flow rate in the range between 20 sccm and 200 sccm may for example be used, the present disclosure not being limited thereto. In embodiments of the present disclosure, a H₂Se flow rate in the range between 20 sccm and 200 sccm may for example be used, the present disclosure not being limited thereto.

CZTSe layers were fabricated in accordance with an embodiment of a method of the present disclosure. Thin layers of Sn, Zn and Cu were sequentially sputtered on a substrate. Afterwards the samples were annealed in an environment containing H₂Se vapour and H₂S vapour, at temperatures in the range between 460°C and 520°C for 15 minutes. In the experiments different H₂Se/H₂S ratios, ranging from 20sscm H₂Se / 180sccm H₂S to 180sccm H₂Se / 20sccm H₂S, were used. The total flow rate (H₂Se + H₂S) was 200 sccm in all experiments. For all H₂Se/H₂S ratios used, Se containing layers free of S were obtained with a well-controlled composition and with a large grain size.

The CZTse layers formed show average grain sizes in the range between 3 micrometer and 5 micrometer. The CZTSe layers also have good physical properties (e.g. band gap, crystal structure), as determined by photoluminescence and X-Ray diffraction. Energy dispersive X-ray analysis EDX showed that the Zn/Sn ratio was almost constant with increasing annealing temperature, which is not the case when using prior art selenization methods, i.e. in the absence of a S containing vapour such as H₂S.

When a prior art selenization process is used, i.e. when the selenization process is done in the absence of a S containing vapour such as H₂S, increasing the annealing temperature to 450°C or higher leads to an exponential increase of the Zn/Sn ratio in the chalcogenide layer. This increase is caused by evaporation of Sn from the metallic layer. It was surprisingly found that this is not the case when introducing a S containing vapour such as H₂S in the selenization chamber, in accordance with the present disclosure.

In embodiments of the present disclosure, the stoichiometric composition of the chalcogenide layer after the annealing is substantially identical to that determined by the composition of the as-deposited metallic layer and its reaction with selenium.

The chalcogenide layer formed according to a method of the present disclosure does not contain sulphur. This was shown based on photoluminescence measurement at room temperature, XRD (X-Ray Diffraction) and EDX (Energy-Dispersive X-ray spectroscopy) measurements.

A chalcogenide layer containing sulphur and selenium may be obtained by performing a sulfurization process, after forming the Se containing chalcogenide layer according to the present disclosure. The sulfurization process may for example comprise annealing in a H₂S environment, not containing Se.

After deposition of the chalcogenide absorption layer, a known photovoltaic cell processing method may be applied, for example including KCN etching, buffer layer deposition and window layer deposition.

The foregoing description details certain embodiments of the disclosure. It will be appreciated, however, that no matter how detailed the foregoing appears in text, the disclosure may be practiced in many ways. It should be noted that the use of particular terminology when describing certain features or aspects of the disclosure should not be taken to imply that the terminology is being re-defined herein to be restricted to including any specific characteristics of the features or aspects of the disclosure with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the invention.

## Claims

1. A method for forming on a substrate a chalcogenide layer, the chalcogenide layer containing at least two different metallic elements and containing Se, the method comprising:
depositing on the substrate a metallic layer containing the at least two metallic elements; and
annealing the metallic layer in an environment comprising both a S containing vapour and a Se containing vapour, thereby forming the chalcogenide layer.

2. The method according to claim 1, wherein the S containing vapour is a H₂S containing vapour.

3. The method according to any of the previous claims, wherein the Se containing vapour is a H₂Se containing vapour.

4. The method according to any of the previous claims, wherein a vapour pressure of the S containing vapour is higher than a vapour pressure of the Se containing vapour.

5. The method according to any of the previous claims, wherein annealing comprises annealing at a temperature in the range between 450°C and 550°C.

6. The method according to any of the previous claims, wherein depositing the metallic layer comprises sequentially depositing the at least two metallic elements.

7. The method according to any of claims 1 to 5, wherein depositing the metallic layer comprises simultaneously depositing the at least two metallic elements.

8. The method according to any of the previous claims, wherein the metallic layer contains three different metallic elements.

9. The method according to claim 8, wherein the metallic layer contains Cu, In and Ga.

10. The method according to claim 8, wherein the metallic layer contains Cu, Zn and Sn.

11. Use of a method according to any of the previous claims for forming a sulphurfree chalcogenide layer.

12. Use of a method according to any of claims 1 to 10 for forming a chalcogenide semiconductor layer.

13. Use of a method according to any of claims 1 to 10 for forming an absorber layer of a photovoltaic cell.
